# EUROPÄISCHE PATENTSCHRIFT

(11) **EP 0 946 966 B1**
(45) Veröffentlichungstag und Bekanntmachung des Hinweises auf die Patenterteilung: **11.05.2005**
(21) Anmeldenummer: 97953901.2
(22) Anmeldetag: 22.12.1997
(51) Int. Cl.: H01J 37/34

(54) **VORRICHTUNG ZUR KATHODENZERSTÄUBUNG**
DEVICE FOR CATHODIC SPUTTERING
DISPOSITIF DE PULVERISATION CATHODIQUE

(30) Priorität: 21.12.1996 DE 19653999; 21.12.1996 DE 19654000; 21.12.1996 DE 19654007
(43) Veröffentlichungstag der Anmeldung: 06.10.1999
(73) Patentinhaber: Singulus Technologies AG, 63755 Alzenau (DE)
(72) Erfinder: SICHMANN, Eggo, D-63571 Gelnhausen (DE); MÜCKE, Michael, D-61184 Karben (DE)
(74) Vertreter: VOSSIUS & PARTNER
(86) Internationale Anmeldenummer: PCT/EP1997/007227
(87) Internationale Veröffentlichungsnummer: WO 1998/028779

(56) Entgegenhaltungen:
- DE-C- 19 654 000
- US-A- 5 330 632

## Beschreibung

Die Erfindung bezieht sich auf eine Vorrichtung zur Kathodenzerstäubung für die Herstellung von Schichten auf einem Substrat mittels einer in einer Vakuumkammer einbringbaren Zerstäubungskathode mit Polschuhen, einem Target und mindestens einem Magneten, wobei im Falle einer kreisförmigen Zerstäubungskathode diese konzentrisch zu den Polschuhen, dem Target und dem Magneten angeordnet ist. Die Form der Zerstäubungskathode des Targets, der Polschuhe und die Magnetanordnung kann an die Form des Substrats angepaßt sein.

Es ist bereits eine Vorrichtung zur Kathodenzerstäubung für die statische Beschichtung scheibenförmiger Substrate mittels eines Plasmas in einer Vakuumkammer mit mindestens einer Öffnung bekannt (DE 43 15 023 A1), welche durch Auflegen einer Zerstäubungskathode von außen verschließbar ist. Zwischen der Kathode und der Kammerwand sind ein elastischer Vakuumdichtring sowie eine ringförmige Anode vorgesehen, die die Öffnungen radial von außen umgeben, wobei die Anode auf ihrer zur Kathode hinzeigenden Seite eine ebene Kontaktfläche aufweist. Die bekannte Zerstäubungskathode besteht aus einem scheibenförmigen, ferromagnetischen Joch und einer Kühlplatte. Zwischen beiden ist ein scheibenförmiger Isolator eingelegt. Vor der Kühlplatte befindet sich das zu zerstäubende Target. Isolator, Kühlplatte, und Target sind von einem Polschuh umgeben; zwischen diesem und dem radial äußeren Bereich des scheibenförmigen Jochs befindet sich ein ringförmigen Magnet. Auf der Rückseite der Kühlplatte ist in einer Nut ein weiterer ringförmig angeordneter Magnet eingelegt. Durch dieser ringförmig angeordneten Magneten wird ein Gegenmagnetfeld erzeugt, welches den Verlauf der Magnetfeldlinien beeinflußt. Hierdurch erhält der Verlauf der Magnetfeldlinien einen annähernd parallelen bzw. linsenförmigen oder konvexen Verlauf.

Eine ähnliche Vorrichtung zur Kathodenzerstäubung ist aus der US 5330632 A bekannt. Auch hier ist ein ringförmiger Magnet zwischen dem Außenbereich eines scheibenförmigen Magnetjochs und einem ringförmigen, das Target umschließenden, Polschuh angeordnet.

Demgemäß liegt der Erfindung die Aufgabe zugrunde, eine Zerstäubungskathode derart auszubilden, daß eine optimale Magnetflußverteilung erreicht wird.

Diese Aufgabe wird erfindungsgemäß durch eine Vorrichtung nach Anspruch 1 gelöst.

Bei der Lösung geht die Erfindung von dem Grundgedanken aus, das Joch symmetrisch zu teilen. Im Falle einer kreisförmigen Zerstäubungskathode ist ein geteiltes Joch bzw. ein aus zwei Teilen gebildetes Joch rotationssymmetrisch zur Mittelachse der Zerstäubungskathode angeordnet. Die geteilte oder auch gestufte Ausbildung der Jochplatte ermöglicht einen sehr einfachen, kostengünstigen Aufbau der Kathode insgesamt und auch den Einsatz eines einfachen, z.B. ringförmig angeordneten Magneten, der z.B. als Quadermagnet und nicht als Ringmagnet ausgebildet sein kann und auf einfache Weise zwischen die Jochplatten gesetzt werden kann. Ringmagneten sind aufwendiger und daher auch teurer als Quadermagneten.

Durch die Verwendung von Magnetspulen, die zum Beispiel unter dem Target oder auch an anderer Stelle angebracht sind, kann man das Magnetfeld im Targetraum gezielt beeinflussen oder variieren, so daß man das Plasma radial von innen nach außen verschieben kann. Hierdurch erreicht man, daß der Erosionsgraben radial über das Target verschoben werden kann, womit man die Möglichkeit hat, entweder einen sehr breiten Erosionsgraben, indem man das Magnetfeld kontinuierlich variiert, oder zwei Erosionsgräben nebeneinander zu erzeugen, indem man das Magnetfeld stufenweise hin- und herschaltet.

Ferner ist es vorteilhaft, daß das geteilte Joch im Bereich des Ringmagneten und mindestens eines ein veränderbares Magnetfeld erzeugenden Teils vorgesehen ist.

Eine zusätzliche Möglichkeit ist gemäß einer Weiterbildung der erfindungsgemäßen Vorrichtung, daß zwischen dem Target oder zwischen der Targetrückseite und der Jochplatte mindestens eine erste ringförmig angeordnete Magnetspule vorgesehen ist.

In weiterer Ausgestaltung der Erfindung ist es vorteilhaft, daß im Bereich des Außenumfangs des Targets die erste Magnetspule und im Bereich des Kühlkopfs die zweite Magnetspule vorgesehen ist.

Gemäß einer bevorzugten Ausführungsform der erfindungsgemäßen Lösung ist schließlich vorgesehen, daß die beiden Magnetspulen etwas oberhalb einer oberen Begrenzung oder der Rückseite des Targets vorgesehen sind.

Von besonderer Bedeutung ist für die vorliegende Erfindung, daß die beiden Magnetspulen auf der gleichen Querebene zwischen der ersten oder zweiten Jochplatte und/oder der Rückseite des Targets angeordnet sind.

Vorteilhaft ist es ferner, daß der im Bereich des Außenumfangs des ersten und/oder zweiten Jochs vorgesehene, ringförmig ausgebildete Magnet zwischen der oberen bzw. zweiten Jochplatte und der unteren bzw. ersten Jochplatte oder zwischen den auf einer Ebene angeordneten Jochplatten vorgesehen ist.

Außerdem ist es vorteilhaft, daß die beiden Magnetspulen und der Ringmagnet konzentrisch zur Mittelachse der Zerstäubungskathode angeordnet sind.

Hierzu ist es vorteilhaft, daß der Ringmagnet einen Außendurchmesser aufweist, der in etwa gleich, etwas kleiner oder etwas größer als der Außendurchmesser der ersten Magnetspule ist.

Ferner ist es vorteilhaft, daß in einem zwischen Target und mindestens einer Jochplatte vorgesehenen Isolator und/oder dem Target Ringkammern zur Aufnahme der Magnetspulen vorgesehen sind.

Eine zusätzliche Möglichkeit ist gemäß einer Weiterbildung der erfindungsgemäßen Vorrichtung, daß die zwei Magnetspulen unterschiedlich große Durchmesser aufweisen.

In weiterer Ausgestaltung der Erfindung ist es vorteilhaft, daß die zweite Magnetspule einen kleineren Außendurchmesser aufweist als die erste Magnetspule.

Ferner ist es vorteilhaft, daß der Ringmagnet eine in Richtung des Substrats zeigende N/S-Polung aufweist.

Auch ist es vorteilhaft, daß ein Eisenkern zwischen den beiden Magnetspulen vorgesehen ist.

Eine zusätzliche Möglichkeit gemäß einer Weiterbildung der erfindungsgemäßen Vorrichtung besteht darin, daß der Eisenkern zweischen einer der Jochplatten und dem Target oder zwischen den Jochplatten und dem Substrat vorgesehen ist.

Von Vorteil ist es ferner, daß der Eisenkern zwischen einer der Jochplatten und/oder dem Isolator und dem Target vorgesehen ist.

Eine wesentliche vorteilhafte Ausführungsform erreicht man dadurch, daß die beiden Jochplatten mit Bezug auf die Mittelachse mit Abstand zueinander und in einer Ebene in einem Targetraum und/oder außerhalb des Targetraums angeordnet sind.

Vorteilhaft ist es außerdem, daß der Abstand zwischen den beiden Jochplatten in etwa der Höhe und/oder Breite des Ringmagneten entspricht.

Ferner ist es vorteilhaft, daß die beiden Jochplatten ringförmige Platten sind und unterschiedlich große Außendurchmesser aufweisen und/oder in Form einer Treppenstufe angeordnet sind.

Eine zusätzliche Möglichkeit ist gemäß einer Weiterbildung der erfindungsgemäßen Vorrichtung, daß die im Außendurchmesser kleinere Jochplatte mit einem Kühlfinger in der Mitte der Zerstäubungskathode und/oder mittel- oder unmittelbar mit einer Hohlschraube und die im Außendurchmesser größere Jochplatte mit dem Polschuh mittel- oder unmittelbar verbunden ist.

In weiterer Ausgestaltung der Erfindung ist es vorteilhaft, daß im Bereich eines Polschuhs ein ein veränderbares Magnetfeld erzeugendes Teil vorgesehen ist.

Gemäß einer bevorzugten Ausführungsform der erfindungsgemäßen Lösung ist schließlich vorgesehen, daß der an die Spulen angelegte Strom in Abhängigkeit von der Zeit veränderbar ist.

Von besonderer Bedeutung ist für die vorliegende Erfindung, daß der an die Spulen angelegte Strom bzw. die Stromzufuhr zu den Spulen über eine Steuerkurve bzw. über ein vorab festgelegtes Programm steuerbar ist und Stromleitungen hierzu über einen Stromteiler mit einem Rechner in Wirkverbindung stehen.

Im Zusammenhang mit der erfindungsgemäßen Ausbildung und Anordnung ist es von Vorteil, daß im Bereich des Außenumfangs der im Durchmesser kleineren Jochplatte die erste Spule und im Bereich des Innenumfangs der zweiten Jochplatte die zweite Spule vorgesehen ist.

Vorteilhaft ist es ferner, daß die beiden ringförmigen Spulen ebenfalls treppenförmig angeordnet sind.

Hierzu ist es vorteilhaft, daß der mit Bezug auf das Target hinter dem Substrat angeordnete Einsenkern zwischen den beiden Spulen auf der gleichen Ebene wie die Spulen angeordnet ist.

Eine weitere vorteilhafte erfindungsgemäße Ausführungsform weist mindestens einen drehbaren Eisenkern auf.

Weitere Vorteile und Einzelheiten der Erfindung sind in den Patentansprüchen und in der Beschreibung erläutert und in den Figuren dargestellt. Es zeigen:
- Fig. 1: eine Schnittdarstellung eines Targets mit mehreren konzentrisch angeordneten Spulen und einem Ring aus Permanentmagneten,
- Fig. 2: eine schematische Darstellung eines treppenförmig ausgebildeten Jochs,
- Fig. 3: eine schematische Darstellung des Feldlinienverlaufs des erfindungsgemäßen Magnetfeldes,
- Fig. 4-6: drei schematische Darstellungen eines treppenförmig ausgebildeten Jochs mit verschiedenen Anordnungen der Spulen bzw. des Abschirmteils, und
- Fig. 7: eine schematische Darstellung eines treppenförmigen Jochs mit verschiedenen Anordnungen von Eisenkernen.

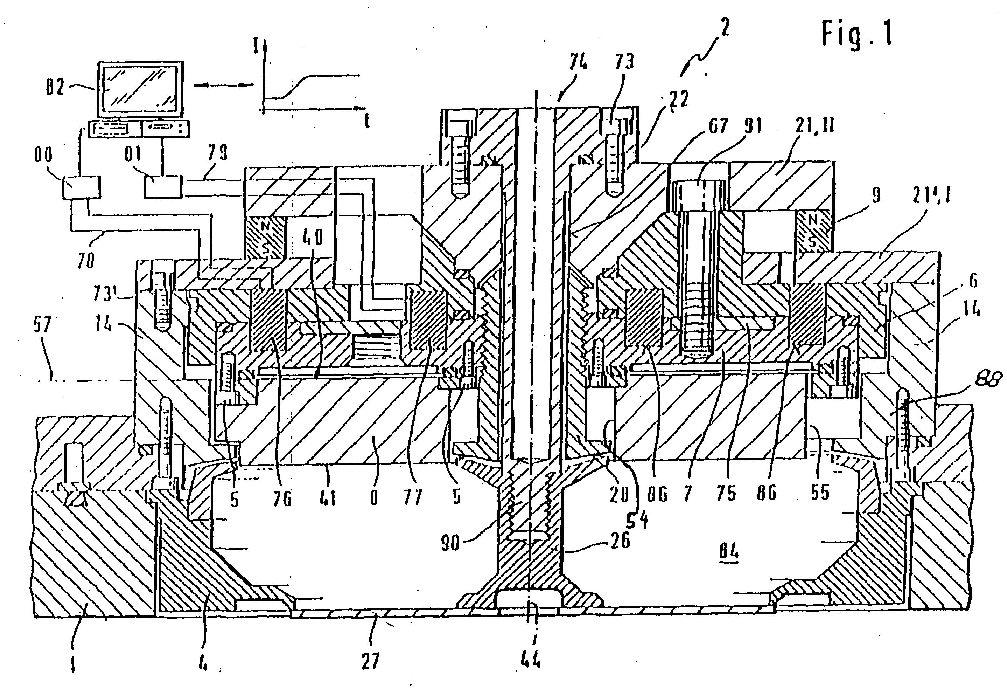

In Fig. 1 ist eine Vorrichtung zur Kathodenzerstäubung für die Herstellung von Schichten auf einem Substrat, beispielsweise einer Compact Disk (CD) 27, dargestellt. Für den Prozeßablauf kann die mit 2 bezeichnete Zerstäubungskathode in eine Kammerwand 1 der Vorrichtung zur Kathodenzerstäubung eingesetzt werden. Die Kathode besteht aus einem scheibenförmigen, ferromagnetischen, ersten, unteren Joch 21' (I) und einem mit Abstand dazu angeordneten, zweiten bzw. oberen Joch 21 (II). Das erste Joch 21' hat einen Durchmesser, der größer ausgebildet ist als der Durchmesser des zweiten Jochs 21.

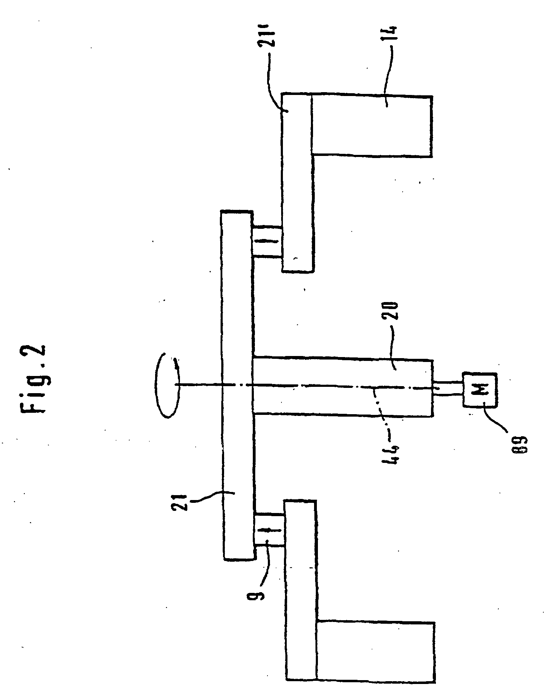

Wie aus den Figuren 1 und 2 hervorgeht, sind die beiden Joche 21, 21' in Form einer Treppenstufe rotationssymmetrisch zu einer Längsmittelachse 44 der Zerstäubungskathode 2 angeordnet und weisen untereinander einen ausreichend großen Abstand auf, so daß in diesen Zwischenraum ein ringförmig angeordneter Magnet 9 ebenfalls rotationssymmetrisch zur Längsmittelachse 44 mit entsprechender Höhe des Zwischenraums angeordnet werden kann. Dieser ringförmig angeordnete Magnet 9 weist mit Bezug auf ein Target 8 eine N/S-Polung auf.

Die im Außendurchmesser kleinere bzw. innere Jochplatte 21 ist mit einem Kühlfinger 74 und die im Außendurchmesser größere Jochplatte 21' mit einem Polschuh 14 mittel- oder unmittelbar verbunden.

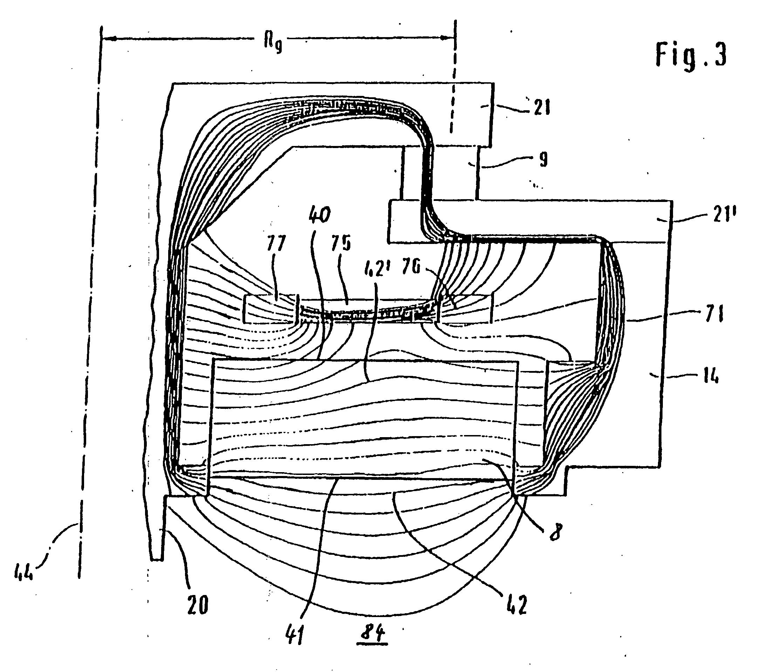

Im Bereich der Jochplatten 21, 21' ist z.B. in Fig. 3 ein ein veränderbares Magnetfeld erzeugendes Teil bzw. eine oder mehrere Magnetspulen 76, 77 vorgesehen.

Die beiden in Fig. 1 dargestellten Magnetspulen 76, 77 liegen auf einer gleichen Querebene unterhalb der unteren, horizontal verlaufenden Ebene der Jochplatte 21'.

Im Bereich des Außenumfangs 55 des Targets 8 kann eine erste Magnetspule 76 und im Bereich des Innenumfangs 54 des Targets 8 bzw. im Bereich des Kühlfingers bzw. Kühlkopfs 74 eine zweite Magnetspule 77 vorgesehen sein. Die beiden Magnetspulen 76, 77 sind etwas oberhalb einer oberen Begren-zung 57 oder der Rückseite 41 des Targets 8 vorgesehen. Es ist dabei vorteilhaft, wenn der im Bereich des Außenumfangs des ersten und/oder zweiten Jochs 21, 21' vorgesehene, z.B. ringförmig angeordnete Magnet 9 zwischen der oberen bzw. zweiten Jochplatte 21 und der unteren bzw. ersten Jochplatte 21' vorgesehen ist und die beiden Magnetspulen 76, 77 und der ringförmig angeordnete Magnet 9 konzentrisch zur Mittelachse 44 der Zerstäubungskathode 2 angeordnet sind.

Die Zerstäubungskathode 2 weist ferner eine Kühlplatte 7 auf. Zwischen dem Joch 21' und der Kühlplatte 7 ist ein Isolator 6 eingeklemmt und mittels Schraubenbolzen 91 gesichert.

Vor der Kühlplatte 7 ist das zu zerstäubende Target 8 angeordnet. Auf der Rückseite der Kühlplatte 7 befindet sich eine bzw. zwei Ringnuten 86 zur Aufnahme einer inneren und einer äußeren Magnetspule 76, 77, die konzentrisch zur Mittelachse 44 des Targets 8 angeordnet sind.

Das Joch bzw. der Isolator 6 und die Kühlplatte 7 werden durch Schrauben 91 und den Kühlfinger 74 gesichert. Die Schraube 91 bzw. eine Schraube 73 ist in vorteilhafter Weise durch den Isolator 6 gegen das Joch isoliert.

An die Magnetspulen 76, 77 kann über elektrische Leitungen 78, 79 eine Stromversorgung angeschlossen werden, die zur Erzeugung des Magnetfelds dient.

Der Magnet 9 ist an das Joch 21 und/oder 21' und den Polschuh 14 zur Leitung des magnetischen Flusses angekoppelt und bildet somit den kompletten Magnetfeldeinschluß.

Das untere Ende des Polschuhs 14 bildet einen Flansch 88, an den die Außenmaske bzw. eine Anode 4 angeschlossen ist. Die Höhe des Polschuhs 14 und/oder die Höhe der Anode 4 ist veränderbar.

Am unteren Ende der Anode 4 befindet sich das Substrat 27, das gemeinsam mit der Anode 4 und der Targetoberfläche 41 den Targetraum 84 einschließt.

Im Bereich der Mittelachse 44 der Zerstäubungskathode 2 befindet sich eine Bohrung 67, die sich durch die gesamte Vorrichtung erstreckt und zur Aufnahme einer Hohlschraube 20 und des Kühlfingers 74 dient. Der Kühlfinger 74 kann mit einer in der Zeichnung nicht dargestellten Kühlleitung verbunden sein.

An das obere Ende der Hohlschraube 20 schließt sich in axialer Richtung berührungsfrei das zweite Joch 21 (II) mit einer Jochplatte an.

Am oberen Ende des Kühlkopfes bzw. des Kühlfingers 74 ist mittels eines Flansches 22 das zweite Joch 21 (II) befestigt, während das erste Joch 21' (I) an den Polschuh 14 angeschlossen ist und mittels Schrauben 73, 73' gesichert werden kann.

An die Stirnseite bzw. an das untere Ende eines Gewindeteils 90 des Kühlfingers 74 ist eine Mittelmaske bzw. eine Mittelanode 26 lösbar angeschlossen. Die Mittelanode 26 reicht bis in die zentrische Vertiefung des Targets 8, welche an der Vorderseite des Targets vorgesehen ist, und bildet mit ihrem unteren Ende mit der Außenanode 4 bzw. Außenmaske eine ringförmige Fläche für die Maskierung des Substrats 27.

Der Abstand zwischen dem ringförmig angeordneten Magneten 9 und der Mittelachse 44 ist je nach Ausführungsform veränderbar. Auf jeden Fall liegt der ringförmig angeordnete Magnet 9 zwischen der Mittelachse 44 und dem Polschuh 14. Wie aus Fig. 1 hervorgeht, kann ein Abschirmteil 75 zwischen den beiden Spulen 76, 77 vorgesehen sein. Ferner ist es möglich, daß das Abschirmteil 75 zwischen einer der Jochplatten 21, 21' und dem Target 8 vorgesehen ist. Das Abschirmteil 75 ist ein Eisenkern für die Spulen 76, 77 und verstärkt deren Magnetfeld, und gleichzeitig schirmt es den Targetraum 84 gegenüber den Kurzschlußfeldlinien des Magneten 9 ab, so daß man mit relativ geringen Strömen mittels der Magnetspulen eine Feldveränderung vornehmen kann. Hierzu kann das Abschirmteil 75 zwischen einer der Jochplatten 21, 21' und/oder dem Isolator 6 sowie dem Target 8 vorgesehen sein. Der Magnet 9 dient zur Erzeugung des Magnetron-Magnetfelds. Gemäß Fig. 3 haben die Feldlinien 71 der Kathode bzw. des Sputter-Magnetrons als Feldlinien 42 einen konvexen Verlauf über der Targetoberfläche 41 und als Feldlinien 42' einen abgeflachten oder in etwa parallelen Verlauf zur Tar-getrückseite 40. Dies wird in vorteilhafter Weise auch durch das Abschirmteil 75 bewirkt. Eine derartige Anordnung eignet sich insbesondere bei einem nicht-ferromagnetischen Metalltarget, z.B. einem Gold- bzw. Aluminium-Target.

Etwas unterhalb des ringförmig angeordneten Magneten 9 befinden sich die beiden Magnetspulen 76, 77. Der ringförmig angeordnete Magnet 9 kann aus zahlreichen einzelnen, ringförmig angeordneten Magneten gebildet sein.

Je nach Ausführung des Targets 8, das beispielsweise als Aluminium-Target oder als Gold-Target ausgebildet sein kann, kann neben dem ersten ringförmg angeordneten Magneten 9 mindestens ein weiterer in der Zeichnung nicht dargestellter, ringförmig angeordneter Magnet in der Nähe des Magneten 9 vorgesehen sein, um die absolute Feldstärke zu erhöhen.

Wie aus Fig. 1 hervorgeht, weist der äußere, ringförmig angeordnete Magnet einen größeren Abstand zur Targerrückseite 40 auf als die beiden Magnetspulen 76, 77.

Die in Fig. 3 dargestellten Magnetspulen 76, 77 dienen zur Variation des Hauptmagnetfelds und können beliebig gepolt sein. Wie aus Fig. 3 hervorgehr, ist der Radius R₉ zwischen der Mittellinie 44 und dem Magneten 9 veränderbar oder so einstellbar, daß sich ein optimales Magnetfeld 42 gemäß Fig. 3 einstellen kann.

Der an die Spulen 76, 77 angelegte Strom I in Abhängigkeit von der Zeit veränderbar. Der an die Spulen 76, 77 angelegte Strom I bzw. die Stromzufuhr zu den Spulen ist über eine Steuerkurve bzw. überein vorab festgelegtes Programm in einem Rechner 82 steuerbar, und die Stromleitungen 78, 79 stehen hierzu über einen Stromteiler 80 mit einem Rechner 82 in Verbindung (Fig. 1). Hierdurch ist eine gezielte Beeinflussung der Targetoberfläche 41 über den gesamten Sputterprozeß möglich, und gleichzeitig wird sichergestellt, daß auf dem Substrat 27 eine sehr gleichmäßige Schichtdicke erzielt wird, wobei die Schichtdickenabweichung zwischen ± 2 % bis 3 % liegen kann. Die erforderliche Steuerkurve läßt sich empirisch ermitteln. Somit kann jeweils für ein entsprechendes Target, z.B. ein Gold- oder Al-Target, eine für die Stromversorgung optimale Steuerkurve ermittelt werden.

Besonders vorteilhaft ist es auch, daß das Joch, wie bereits erwähnt, nicht einteilig ausgebildet ist, sondern geteilt wurde und aus zwei einzelnen Teilen, also einer oberen und einer unteren Jochplatte 21, 21', besteht, die aus zwei rotationssymmetrischen Scheiben bestehen und mit Abstand zueinander angeordnet sein können, so daß mindestens ein Magnet 9 zwischen diesen vorgesehen werden kann.

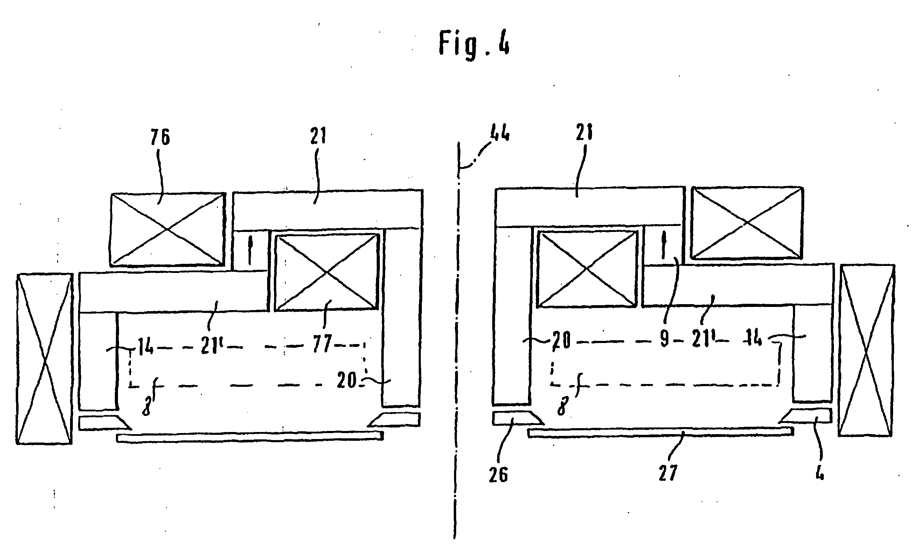

In den Figuren 4 bis 6 sind weitere Ausführungsbeispiele der Vorrichtung zur Kathodenzerstäubung für die Herstellung von Schichten auf einem Substrat 27 gezeigt, in denen die Jochplatten 21, 21' bzw. der Polschuh 14 und die Spulen 76, 77 auch anders ausgebildet bzw. angeordnet sein können.

Gemäß Fig. 4 sind die Jochplatten 21, 21' ebenfalls stufenartig ausgebildet, wobei die obere Jochplatte gemäß Fig. 4 mit ihrem inneren Rand an die Hohlschraube 20 und der außenliegende Rand über den ringförmig angeordneten Magneten 9 an den innenliegenden Rand der unteren stufenartig versetzten ersten Jochplatte 21' angeschlossen ist. Der äußere Rand der ersten Jochplatte 21' ist an den Polschuh 14 angeschlossen.

Die erste Spule 76, die im Durchmesser größer ist als die zweite Spule 77, befindet sich oberhalb der oberen Jochplatte 21 zwischen dem außenliegenden Rand der oberen Jochplatte 21 und dem außenliegenden Rand der unteren Jochplatte, während die zweite im Durchmesser kleinere Spule 77 sich unterhalb der oberen Jochplatte 21 zwischen dem innenliegenden Rand der unteren Jochplatte 21' und der Hohlschraube 20 befindet. Die übrige Anordnung dieser Vorrichtung entspricht der Anordnung der Vorrichtung gemäß Fig. 1.

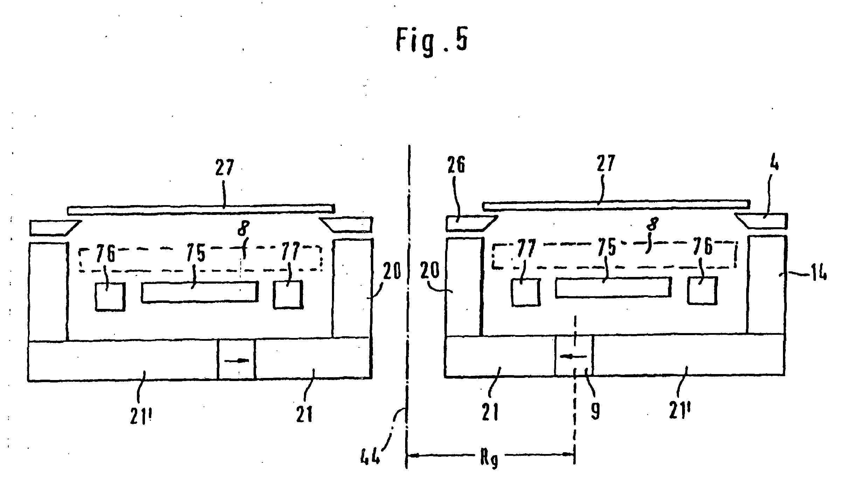

Im Ausführungsbeispiel gemäß Fig. 5 sind die Jochplatten 21, 21' ebenfalls geteilt, und diese sind ebenfalls als ringförmige Jochplatten 21, 21' mit unterschiedlich großem Durchmesser ausgebildet, wobei beide Jochplatten auf einer mit Bezug auf die Standfläche der Vorrichtung horizontalen Ebene angeordnet sind, die die Mittelachse 44 in einem rechten Winkel schneiden.

Zwischen den beiden Jochplatten 21, 21' liegt der ringförmige Magnet 9.

Die beiden ringförmig angeordneten Spulen 76, 77 umgeben den Abschirmteil 75 und befinden sich gemäß Fig. 5. im Targetraum 84.

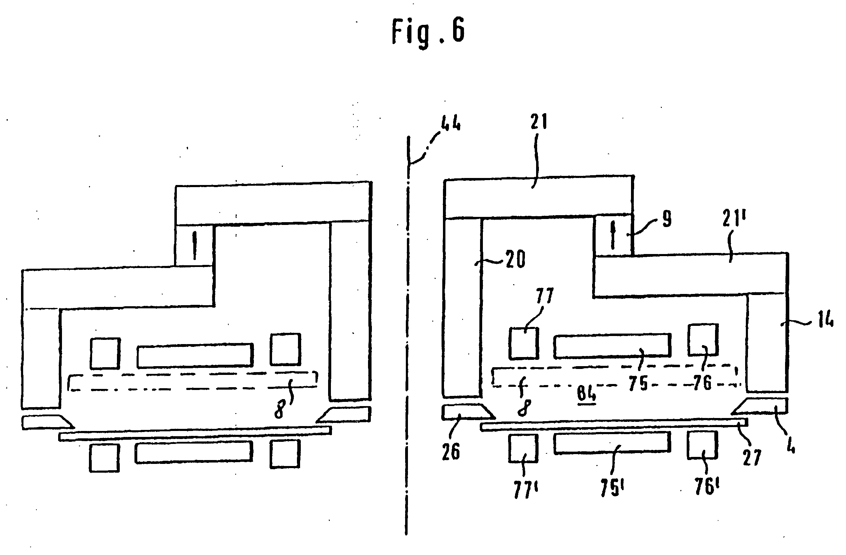

Das Ausführungsbeispiel gemäß Fig. 6 unterscheidet sich vom Ausführungsbeispiel gemäß Fig. 5 nur dadurch, daß ein zweites Abschirmteil 75' mit zwei ringförmigen Spulen 76', 77' in der gleichen Anordnung gemäß Fig. 5 sich außerhalb des Tärgetraums 84 befindet.

Die Schirmplatte 75 im Targetraum 84 oder die Schirmplatte 75' außerhalb des Targetraums 84 mit den beiden Spulen 76, 77 bzw. 76', 77' dienen dazu, das Magnetfeld gezielt und noch optimaler zu beeinflussen. Hierdurch wird die Linsenform der Magnetflußlinien (vgl. Magnetfeld 42) beeinflußt. Durch die linsenförmige Ausbildung des Magnetfelds 42 gemäß Fig. 3 wird der Einschluß der Elektronen auf dem Target 8 bewirkt, die zum Ionisieren der Nutzgasatome in der Zerstäubungskammer, z.B. der Argonatome dienen; die Elektronen werden mittels des Magnetfelds über dem Target 8 gehalten und können in optimaler Weise nicht auf die Anode abfließen und nehmen dadurch auch mehrmals an der Ionisation teil. Hierdurch wird also zusätzlich gewährleistet, daß eine gleichmäßige Schichtdicke auf der Oberfläche des Substrats 27 erreicht wird.

Durch diese beschriebene Anordnung wird unter Berücksichtigung der Strom-Zeit-Funktion (f_{(I)} = I₍ₜ₎) eine optimale Schichtdicken-Gleichmäßigkeit erreicht. Bei dieser Anordnung wird, wie bereits erwähnt, der Strom in Abhängigkeit der Targetoberfläche variiert. Durch unterschiedliches Belegen der Spulen 76, 77 mit Strom erreicht man, daß das Plasma radial oberhalb der Targetoberfläche 41 verschoben werden kann. Das heißt, daß das Plasma mit Bezug auf die Oberfläche des Targets 8 entweder nach links oder rechts verschoben wird. Hierdurch kann die Oberflächenschicht des Substrats 27 gezielt besputtert bzw. aufgebaut werden.

Die gestufte Ausbildung der Jochplatten 21, 21' ermöglicht einen sehr einfachen, kostengünstigen Aufbau der Kathode insgesamt und auch den Einsatz eines einfachen ringförmig angeordneten Magneten, der z.B. als Quadermagnet und nicht als Ringmagnet ausgebildet sein kann und auf einfache Weise zwischen die Jochplatten 21, 21' gesetzt werden kann. Ringmagneten sind aufwendiger und daher auch teurer als Quadermagneten.

Gemäß Fig. 4 sind die Spulen 76, 77 weiter entfernt vom Target 8 als die Spulen der Beispiele gemäß Fig. 5 und 6. Die Spulen gemäß Fig. 1 müssen daher größer ausgebildet sein und mit mehr Strom beschickt werden als die Spulen 76, 77 der Beispiele gemäß Fig. 5 und 6. Man kann gemäß Fig. 1 das Plasma ebenso hin- und herschieben wie bei den anderen Ausführungsbeispielen, wobei der Energieaufwand gemäß Fig. 1 etwas höher ist.

Die einzelnen Spulen sind unterschiedlich stark beeinflußbar und können je nach Ausführungsbeispiel gekoppelt oder nicht gekoppelt sein. Die Spulen 76, 77 können z.B. in Reihe geschaltet werden.

Vorteilhaft ist es, wenn durch die Verwendung der Magnetspulen, die zum Beispiel unter dem Target oder auch an anderer Stelle, wie bereits erläutert, angebracht worden sind, das Magnetfeld im Targetraum gezielt beeinflußt und variiert werden kann, so daß man das Plasma radial von innen nach außen verschieben kann. Hierdurch erreicht man, daß der Erosionsgraben radial über das Target verschoben werden kann, womit man die Möglichkeit hat, einmal einen sehr breiten Erosionsgraben, indem man das Magnetfeld kontinuierlich variiert, oder zwei Erosionsgräben nebeneinander zu erzeugen, indem man das Magnetfeld stufenweise hin- und herschaltet.

Die Schichtdicken-Gleichmäßigkeit kann dadurch erreicht werden, daß ein sich zeitlich änderndes Magnetfeld dem stationären Magnetfeld hinzugefügt (überlagert) wird. Dieses variable Magnetfeld dient der Schichtdicken-Optimierung über einen Beschichtungszyklus. Hierzu wird eine empirisch zu definierende Strom-Zeit-Funktion erstellt wie etwa in der DE-B-196 54 000 näher erläutert.

Die gemäß Figuren 5 und 6 im Targetinnenraum 84 vorgesehenen Spulen 76, 77 dienen hauptsächlich dazu, das Magnetfeld im Targetraum zu beeinflussen. Um das Magnetfeld außerhalb des Targetraums 84 zu beeinflussen, werden gemäß Fig. 6 die zusätzlichen Spulen 76', 77' und das Schirmblech 75' vorgesehen.

In den Ausführungsbeispielen kann auch das Joch 21, 21' vertikal mit Bezug auf die Mittellinie 44 geteilt werden. Hierdurch kann der Magnet 9 so angeordnet werden, daß der magnetische Fluß gezielt auf die Hohlschraube 20 und auf den Polschuh 14 verteilt werden kann. Hierdurch kann man ein homogenes horizontales Magnetfeld im Targetraum 84 erhalten. Dieses Magnetfeld ist dann ebenfalls durch die Spulen 76, 77, wie bereits erläutert, gezielt beeinflußbar.

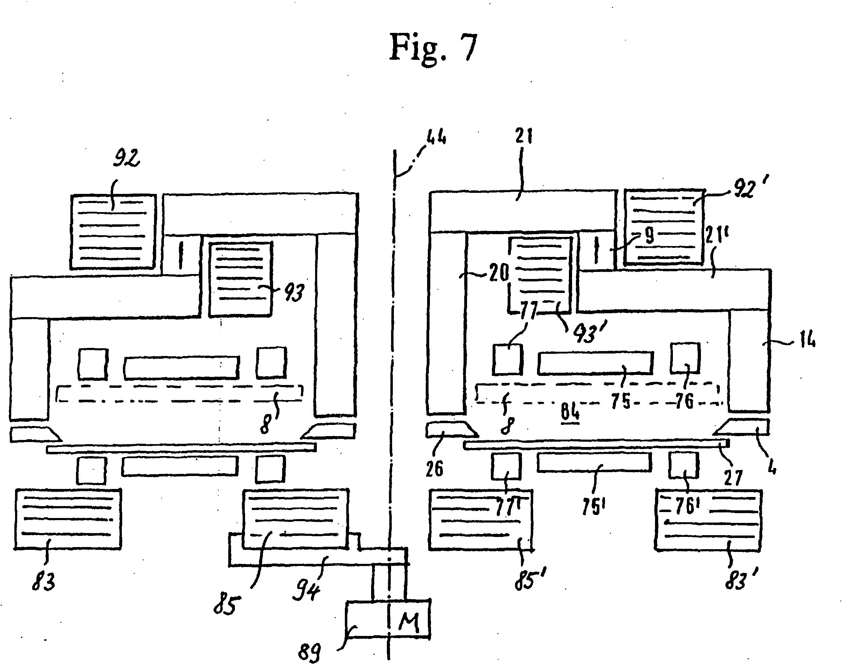

Fig. 7 zeigt ein Ausführungsbeispiel für die Anordnung von vier um die Achse 44 drehbaren Eisenkernen 83, 85, 92 und 93; die Drehhalterung 94 des Eisenkerns 85 ist schematisch dargestellt. Die Position der Eisenkerne nach Drehung um 180° ist gestrichelt eingezeichnet und mit 83', 85', 92' und 93' gekennzeichnet. Im Rahmen der Erfindung kann eine beliebige Anzahl von derartigen Eisenkernen vorgesehen sein, wobei ein oder zwei Eisenkerne bevorzugt sind. Durch geeignete Drehung der Eisenkerne um die Achse 44 wird das Magnetfeld im Bereich der Oberfläche des Targets 8 zeitabhängig verändert und zur Erzielung einer hohen Schichtdickengleichmäßigkeit und hoher Targetausbeute optimiert.

Wie in Ausführungsbeispiel gemäß Fig. 7 dargestellt, kann das Joch 21, 21' ebenfalls geteilt und rotationssymmetrisch ausgebildet sein; ferner kann z.B., im Bereich des Ringmagneten 9 noch mindestens eine ein veränderbares Magnetfeld erzeugende Magnetspule (nicht dargestellt) vorgesehen sein.

## Patentansprüche

1. Vorrichtung zur Kathodenzerstäubung für die Herstellung von Schichten auf einem Substrat (27) mittels einer in eine Vakuumkammer einbringbaren Zerstäubungskathode (2), die Polschuhe (14), ein Target (8) und mindestens einen Magneten bzw. Ringmagneten (9) aufweist, **dadurch gekennzeichnet, daß**
a) eine erste und eine zweite Jochplatte (21,21') vorgesehen sind, die sich in der Zerstäubungskathode (2) von innen nach außen erstrecken, wobei die zweite Jochplatte (21') sich am weitesten nach außen erstreckt, und
b) der Magnet (9) zwischen der ersten und der zweiten Jochplatte (21, 21') angeordnet ist.

2. Vorrichtung nach Anspruch 1, wobei die erste und die zweite Jochplatte (21, 21') in bezug auf die Ebene der Jochplatten vertikal versetzt angeordnet sind.

3. Vorrichtung nach Anspruch 1, wobei die erste und die zweite Jochplatte (21, 21') in einer Ebene angeordnet sind.

4. Vorrichtung nach einem der Ansprüche 1 bis 3, wobei die Zerstäubungskathode (2) kreisförmig, ist und die Polschuhe (14) und die erste und zweite Jochplatte (21, 21') zur Zerstäubungskathode (2) koaxial angeordnet sind.

5. Vorrichtung nach einem der Ansprüche 1 bis 4, wobei mindestens ein ein veränderbares Magnetfeld erzeugendes Teil (76, 77) oder mindestens ein drehbarer Eisenkern (83, 85, 92, 93) vorgesehen ist.

6. Vorrichtung nach Anspruch 5, wobei die Jochplatten (21, 21') im Bereich des Ringmagneten (9) und des mindestens eines ein veränderbares Magnetfeld erzeugenden Teils (76, 77) oder des mindestens einen drehbaren Eisenkerns (83, 85, 92, 93) vorgesehen sind.

7. Vorrichtung nach Anspruch 5 oder 6, wobei zwischen dem Target (8) oder zwischen der Targetrückseite (40) und der Jochplatte (21, 21') mindestens eine erste ringförmig angeordnete Magnetspule (76) vorgesehen ist.

8. Vorrichtung nach einem der Ansprüche 5 bis 7, wobei im Bereich des Außenumfangs (55) des Targets (8) eine erste Magnetspule (76) und im Bereich des Innenumfangs (54) des Targets (8) eine zweite Magnetspule (77) vorgesehen ist.

9. Vorrichtung nach Anspruch 8, wobei die beiden Magnetspulen (76, 77) etwas oberhalb einer oberen Begrenzung (57) oder der Rückseite (40) des Targets (8) vorgesehen sind.

10. Vorrichtung nach Anspruch 8 oder 9, wobei die beiden Magnetspulen (76, 77) in der gleichen Querebene angeordnet sind.

11. Vorrichtung nach Anspruch 10, wobei die beiden Magnetspulen (76, 77) in der gleichen Querebene zwischen der ersten oder zweiten Jochplatte (21, 21') und/oder der Rückseite (40) des Targets (8) angeordnet sind.

12. Vorrichtung nach einem der Ansprüche 2 bis 11, wobei der ringförmig ausgebildete Magnet (9) im Bereich des Außenumfangs der ersten Jochplatte (21) zwischen der oberen ersten (21) und der unteren zweiten Jochplatte (21') oder zwischen den auf einer Ebene angeordneten Jochplatten (21, 21') vorgesehen ist.

13. Vorrichtung nach einem der Ansprüche 8 bis 12, wobei die beiden Magnetspulen (76, 77) konzentrisch zur Mittelachse (44) der Zerstäubungskathode (2) angeordnet sind.

14. Vorrichtung nach Anspruch 7 bis 13, wobei der Magnet (9) einen Außendurchmesser aufweist, der in etwa gleich, etwas kleiner oder etwas größer als der Außendurchmesser der ersten Spule (76) ist.

15. Vorrichtung nach einem der Ansprüche 8 bis 14, wobei in einem zwischen Target (8) und mindestens einer Jochplatte (21, 21') vorgesehenen Isolator (6) und/oder dem Target (8) Ringkammern (86) zur Aufnahme der Magnetspulen (76, 77) vorgesehen sind.

16. Vorrichtung nach einem der Ansprüche 8 bis 15, wobei die zwei Magnetspulen (76, 77) unterschiedlich große Durchmesser aufweisen.

17. Vorrichtung nach Anspruch 16, wobei die zweite Magnetspule (77) einen kleineren Außendurchmeser aufweist als die erste Ringspule (76).

18. Vorrichtung nach einem der Ansprüche 1 bis 17, wobei der Ringmagnet (9) eine in Richtung des Substrats (27) zeigende N/S-Polung aufweist.

19. Vorrichtung nach einem der Ansprüche 8 bis 18, wobei ein Eisenkern (75) zwischen den beiden Spulen (76, 77) vorgesehen ist.

20. Vorrichtung nach Anspruch 19, wobei oder Eisenkern (75) zwischen einer der Jochplatten (21, 21') und dem Target (8) oder zwischen den Jochplatten (21, 21') und dem Substrat (27) vorgesehen ist.

21. Vorrichtung nach Anspruch 19 oder 20, wobei der Eisenkern (75) zwischen einer der Jochplatten (21, 21') und/oder dem Isolator (6) und dem Target (8) vorgesehen ist.

22. Vorrichtung nach einem der Ansprüche 3 bis 21, wobei die beiden Jochplatten (21, 21') mit Bezug auf die Mittelachse (44) der Zerstäubungskathode (2) Abstand zueinander und in einer Ebene in einem Targetraum (84), der durch das Target (8) und das Substrat (27) begrenzt ist, und/oder außerhalb des Targetraums (84) angeordnet sind.

23. Vorrichtung nach einem der Ansprüche 1 bis 22, wobei der Abstand zwischen den beiden Jochplatten (21, 21') in etwa der Höhe und/oder Breite des Magneten (9) entspricht.

24. Vorrichtung nach einem der Ansprüche 1 bis 23, wobei die beiden Jochplatten (21, 21') ringförmige Platten sind und unterschiedlich große Außendurchmesser aufweisen und/oder in Form einer Treppenstufe angeordnet sind.

25. Vorrichtung nach einem der Ansprüche 1 bis 24, wobei die im Außendurchmesser kleinere Jochplatte (21) mit einem Kühlfinger (74) in der Mitte der Zerstäubungskathode (2) und/oder mittel- oder unmittelbar mit einer Hohlschraube (20) und die im Außendurchmesser größere Jochplatte (21') mit dem Polschuh (14) mittel- oder unmittelbar verbunden ist.

26. Vorrichtung nach einem der Ansprüche 1 bis 25, wobei im Bereich eines Polschuhs (14) ein ein veränderbares Magnetfeld erzeugendes Teil vorgesehen ist.

27. Vorrichtung nach einem der Ansprüche 5 bis 7, wobei im Bereich des Außenumfangs der im Durchmesser kleineren Jochplatte (21) die erste Spule (76) und im Bereich des Innenumfangs der zweiten Jochplatte (21') die zweite Spule (77) vorgesehen ist.

28. Vorrichtung nach Anspruch 27, wobei die beiden ringförmigen Spulen (76, 77) treppenförmig angeordnet sind.

29. Vorrichtung nach einem der Ansprüche 1 bis 28, wobei der an die Spulen (76, 77) angelegte Strom in Abhängigkeit von der Zeit veränderbar ist.

30. Vorrichtung nach einem der Ansprüche 1 bis 29, wobei der an die Spulen (76, 77) angelegte Strom bzw. die Stromzufuhr zu den Spulen über eine Steuerkurve bzw. über ein vorab festgelegtes Programm steuerbar ist und Stromleitungen (78, 79) hierzu über einen Stromteiler (80) mit einem Rechner (82) in Verbindung stehen.

31. Vorrichtung nach einem der Ansprüche 1 bis 30 wobei mit Bezug auf das Target (8) hinter dem Substrat (27) ein Eisenkern (75') zwischen den beiden Spulen (77' und 76') in der gleichen Ebene wie die Spulen angeordnet ist.

32. Vorrichtung nach einem der Ansprüche 8 bis 27, 29 und 30, wobei der Eisenkern (75) zwischen den beiden Spulen (77, 76) in der gleichen Ebene wie die Spulen angeordnet ist.

## Claims

1. A device for cathode sputtering for producing coatings on a substrate (27) by means of a sputtering cathode (2) arrangeable in a vacuum chamber and comprising pole shoes (14), a target (8) and at least one magnet or ring magnet (9), **characterized in that**
(a) first and second yoke plates (21, 21') are provided which extend in the sputtering cathode (2) from inside to outside, wherein the second yoke plate (21') extends farthest to the outside, and
(b) the magnet (9) is arranged between the first and second yoke plates (21, 21').

2. The device according to claim 1, wherein the first and the second yoke plates (21, 21') are displaced vertically with respect to the plane of the yoke plates.

3. The device according to claim 1, wherein the first and the second yoke plates (21, 21') are arranged in one plane.

4. The device according to any one of claims 1 to 3, wherein the sputtering cathode (2) is circular and the pole shoes (14) and the first and second yoke plates (21, 21') are arranged coaxially with respect to the sputtering cathode (2).

5. The device according to any one of claims 1 to 4, wherein at least one means (76, 77) generating a variable magnetic field or at least one rotatable iron core (83, 85, 92, 93) is provided.

6. The device according to claim 5, wherein the yoke plates (21, 21') are provided in the area of the ring magnet (9) and the at least one means (76, 77) generating a variable magnetic field or the at least one rotatable iron core (83, 85, 92, 93).

7. The device according to claim 5 or 6, wherein at least one first annularly arranged magnetic coil (76) is provided between the target (8) or between the back surface (40) of the target and the yoke plate (21, 21').

8. The device according to any one of claims 5 to 7, wherein a first magnetic coil (76) is provided in the area of the outer circumference (55) of the target (8) and a second magnetic coil (77) is provided in the area of the inner circumference (54) of the target (8).

9. The device according to claim 8, wherein the two magnetic coils (76, 77) are provided slightly above an upper limit (57) or the back surface (40) of the target (8).

10. The device according to claim 8 or 9, wherein the two magnetic coils (76, 77) are arranged in the same transverse plane.

11. The device according to claim 10, wherein the two magnetic coils (76, 77) are arranged in the same transverse plane between the first or second yoke plates (21, 21') and/or the back surface (40) of the target (8).

12. The device according to any one of claims 2 to 11, wherein the ring magnet (9) is provided in the area of the outer circumference of the first yoke plate (21) between the upper first (21) and the lower second yoke plate (21') or between the yoke plates (21, 21') arranged in one plane.

13. The device according to any one of claims 8 to 12, wherein the two magnetic coils (76, 77) are arranged concentrically with respect to the center axis (44) of the sputtering cathode (2).

14. The device according to claims 7 to 13, wherein the magnet (9) has an outer diameter which is about as large as, slightly smaller or slightly larger than the outer diameter of the first coil (76).

15. The device according to any one of claims 8 to 14, wherein ring chambers (86) for receiving the magnetic coils (76, 77) are provided in an insulator (6), which is provided between the target (8) and at least one yoke plate (21, 21'), and/or in the target (8).

16. The device according to any one of claims 8 to 15, wherein the two magnetic coils (76, 77) have different diameters.

17. The device according to claim 16, wherein the second magnetic coil (77) has a smaller outer diameter than the first ring coil (76).

18. The device according to any one of claims 1 to 17, wherein the ring magnet (9) has an N/S polarity directed towards the substrate (27).

19. The device according to any one of claims 8 to 18, wherein an iron core (75) is provided between the two coils (76, 77).

20. The device according to claim 19, wherein the iron core (75) is provided between one of the yoke plates (21, 21') and the target (8) or between the yoke plates (21, 21') and the substrate (27).

21. The device according to claim 19 or 20, wherein the iron core (75) is provided between one of the yoke plates (21, 21') and/or the insulator (6) and the target (8).

22. The device according to any one of claims 3 to 21, wherein the two yoke plates (21, 21') are spaced from each other with respect to the center axis (44) of the sputtering cathode (2) and are arranged in a plane in a target space (84) limited by the target (8) and the substrate (27) and/or outside the target space (84).

23. The device according to any one of claims 1 to 22, wherein the distance between the two yoke plates (21, 21') approximately corresponds to the height and/or width of the magnet (9).

24. The device according to any one of claims 1 to 23, wherein the two yoke plates (21, 21') are annular plates having different outer diameters and/or being arranged in the form of a step.

25. The device according to any one of claims 1 to 24, wherein the yoke plate (21) having a smaller outer diameter is connected with a cooling finger (74) in the center of the sputtering cathode (2) and/or indirectly or directly with a hollow screw (20), and that the yoke plate (21') having a larger outer diameter is indirectly or directly connected with the pole shoe (14).

26. The device according to any one of claims 1 to 25, wherein a means generating a variable magnetic field is provided in the area of a pole shoe (14).

27. The device according to any one of claims 5 to 7, wherein the first coil (76) is provided in the area of the outer circumference of the yoke plate (21) having a smaller diameter and the second coil (77) is provided in the area of the inner circumference of the second yoke plate (21').

28. The device according to claim 27, wherein the two ring coils (76, 77) are arranged in a stepped way.

29. The device according to any one of claims 1 to 28, wherein the current fed to the coils (76, 77) can be varied depending on the time.

30. The device according to any one of claims 1 to 29, wherein the current fed to the coils (76, 77) or the current supply to the coils can be controlled via a control curve or a preset program and that for this purpose current conductors (78, 79) are connected with a computer (82) via a current divider (80).

31. The device according to any one of claims 1 to 30, wherein with respect to the target (8), an iron core (75') is arranged behind the substrate (27) between the two coils (77' and 76') in the same plane as the coils.

32. The device according to any one of claims 8 to 27, 29 and 30, wherein the iron core (75) is arranged between the two coils (77, 76) in the same plane as the coils.

## Revendications

1. Dispositif de pulvérisation cathodique pour la formation de couches sur un substrat (27) au moyen d'une cathode de pulvérisation (2) pouvant être introduite dans une chambre à vide, qui présente des patins polaires (14), une cible (8) et au moins un aimant, en particulier un aimant annulaire (9), **caractérisé en ce que**
a) une première et une deuxième carcasse (21, 21'), qui s'étendent de l'intérieur vers l'extérieur dans la cathode de pulvérisation (2), sont prévues, la deuxième carcasse (21') s'étendant le plus loin vers l'extérieur, et
b) l'aimant (9) est disposé entre la première et la deuxième carcasse (21, 21').

2. Dispositif selon la revendication 1, dans lequel la première et la deuxième carcasse (21, 21') sont décalées dans le sens vertical par rapport au plan des carcasses.

3. Dispositif selon la revendication 1, dans lequel la première et la deuxième carcasse (21, 21') sont disposées dans un même plan.

4. Dispositif selon l'une des revendications 1 à 3, dans lequel la cathode de pulvérisation (2) est circulaire, et les patins polaires (14) et la première et la deuxième carcasse (21, 21') sont disposés coaxialement à la cathode de pulvérisation (2).

5. Dispositif selon l'une des revendications 1 à 4, dans lequel au moins un élément (76, 77) produisant un champ magnétique variable ou au moins un noyau de fer rotatif (83, 85, 92, 93) est prévu.

6. Dispositif selon la revendication 5, dans lequel les carcasses (21, 21') sont prévues dans la zone de l'aimant annulaire (9) et du au moins un élément (76, 77) produisant un champ magnétique variable ou du au moins un noyau de fer rotatif (83, 85, 92, 93).

7. Dispositif selon la revendication 5 ou 6, dans lequel au moins une première bobine (76) d'électro-aimant annulaire est prévue entre la cible (8) ou entre la face arrière (40) de la cible et la carcasse (21, 21').

8. Dispositif selon l'une des revendications 5 à 7, dans lequel une première bobine (76) d'électro-aimant est prévue dans la zone (55) de la périphérie externe de la cible (8) et une deuxième bobine (77) d'électro-aimant est prévue dans la zone (54) de la périphérie interne de la cible (8).

9. Dispositif selon la revendication 8, dans lequel les deux bobines (76, 77) d'électro-aimant sont prévues légèrement au-dessus d'une limite supérieure (57) ou de la face arrière (40) de la cible (8).

10. Dispositif selon la revendication 8 ou 9, dans lequel les deux bobines (76, 77) d'électro-aimant sont disposées dans un même plan transversal.

11. Dispositif selon la revendication 10, dans lequel les deux bobines (76, 77) d'électro-aimant sont disposées dans le même plan transversal entre la première et la deuxième carcasse (21, 21') et/ou la face arrière (40) de la cible (8).

12. Dispositif selon l'une des revendications 2 à 11, dans lequel l'aimant annulaire (9) est prévu dans la zone de la périphérie externe de la première carcasse (21) entre la première carcasse supérieure (21) et la deuxième carcasse inférieure (21') ou entre les carcasses (21, 21') disposées dans un même plan.

13. Dispositif selon l'une des revendications 8 à 12, dans lequel les deux bobines (76, 77) d'électro-aimant sont disposées concentriquement à l'axe central (44) de la cathode de pulvérisation (2).

14. Dispositif selon l'une des revendications 7 à 13, dans lequel l'aimant (9) présente un diamètre externe qui est à peu près égal, un peu plus petit ou un peu plus grand, au diamètre externe de la première bobine (76).

15. Dispositif selon l'une des revendications 8 à 14, dans lequel des espaces annulaires (86) pour loger les bobines (76, 77) d'électro-aimant sont prévus dans un isolateur (6) prévu entre la cible (8) et au moins une carcasse (21, 21') et/ou dans la cible (8).

16. Dispositif selon l'une des revendications 8 à 15, dans lequel les deux bobines (76, 77) d'électro-aimant présentent un diamètre différent.

17. Dispositif selon la revendication 16, dans lequel la deuxième bobine (77) d'électro-aimant présente un diamètre externe plus petit que celui de la première bobine annulaire (76).

18. Dispositif selon l'une des revendications 1 à 17, dans lequel l'aimant annulaire (9) présente une polarité N/S dirigée vers le substrat (27).

19. Dispositif selon l'une des revendications 8 à 18, dans lequel un noyau de fer (75) est prévu entre les deux bobines (76, 77).

20. Dispositif selon la revendication 19, dans lequel le noyau de fer (75) est prévu entre l'une des carcasses (21, 21') et la cible (8) ou entre les carcasses (21, 21') et le substrat (27).

21. Dispositif selon la revendication 19 ou 20, dans lequel le noyau de fer (75) est prévu entre l'une des carcasses (21, 21') et/ou l'isolateur (6) et la cible (8).

22. Dispositif selon l'une des revendications 3 à 21, dans lequel les deux carcasses (21, 21') sont disposées à distance l'une de l'autre par rapport à l'axe central (44) de la cathode de pulvérisation (2) et dans un même plan dans un espace cible (84), qui est délimité par la cible (8) et le substrat (27), et/ou hors de l'espace cible (84).

23. Dispositif selon l'une des revendications 1 à 22, dans lequel la distance entre les deux carcasses (21, 21') correspond à peu près à la hauteur et/ou à la largeur de l'aimant (9).

24. Dispositif selon l'une des revendications 1 à 23, dans lequel les deux carcasses (21, 21') sont des plaques annulaires et présentent un diamètre externe différent et/ou sont disposés en escalier.

25. Dispositif selon l'une des revendications 1 à 24, dans lequel la carcasse ayant le plus petit diamètre externe (21) est reliée à une bougie de refroidissement (74) au milieu de la cathode de pulvérisation (2) et/ou directement ou indirectement à un boulon creux (20), et la carcasse ayant le plus grand diamètre externe (21') est reliée directement ou indirectement au patin polaire (14).

26. Dispositif selon l'une des revendications 1 à 25, dans lequel un élément produisant un champ magnétique variable est prévu dans la zone d'un patin polaire (14).

27. Dispositif selon l'une des revendications 5 à 7, dans lequel la première bobine (76) est prévue dans la zone de la périphérie externe de la carcasse (21) ayant le plus petit diamètre et la deuxième bobine (77) est prévue dans la zone de la périphérie interne de la deuxième carcasse (21').

28. Dispositif selon la revendication 27, dans lequel les deux bobines annulaires (76, 77) sont disposées en escalier.

29. Dispositif selon l'une des revendications 1 à 28, dans lequel le courant appliqué aux bobines (76, 77) est variable dans le temps.

30. Dispositif selon l'une des revendications 1 à 29, dans lequel le courant appliqué aux bobines (76, 77) ou l'alimentation en courant des bobines est commandable selon une courbe de commande ou un programme défini au préalable, et les lignes d'alimentation (78, 79) prévues à cet effet sont reliées à un ordinateur (82) par l'intermédiaire d'un diviseur de puissance (80).

31. Dispositif selon l'une des revendications 1 à 30, dans lequel un noyau de fer (75') est disposé à l'arrière du substrat (27) par rapport à la cible (8) entre les deux bobines (77' et 76') dans le même plan que les bobines.

32. Dispositif selon l'une des revendications 8 à 27, 29 et 30, dans lequel le noyau de fer (75) est disposé entre les deux bobines (77, 76) dans le même plan que les bobines.
